# EUROPÄISCHE PATENTANMELDUNG

(11) **EP 0 949 759 A1**
(43) Veröffentlichungstag der Anmeldung: **13.10.1999**
(21) Anmeldenummer: 98106995.8
(22) Anmeldetag: 09.04.1998
(51) Int. Cl.: H03K 5/08

(54) **Anordnung zur Erzeugung eines Ausgangssignals aus einem Eingangssignal in einem Elektrizitätszähler, einem Rundsteuerempfänger, einer Kombination derselben und/oder einem zugehörigen Zusatzgerät, wobei das Ausgangssignal unabhängig vom Pegel des Eingangssignals einen definierten Pegel besitzt**

(71) Anmelder: Electrowatt Technology Innovation AG, 6301 Zug (CH)
(72) Erfinder: Amstad, Reto, Dipl. Ing., 6330 Cham (CH)

(57) **Zusammenfassung**

Das Eingangssignal (u_{E}) der Anordnung weist einen grossen Pegelbereich auf und ist auf eine Vergleichsanordnung (3) geführt zum dortigem Vergleich mit einem Schwellwert (U_{T}). Ein Ausgangssignal (u_{V}) der Vergleichsanordnung (3) besitzt unabhängig vom Pegel des Eingangssignals (u_{E}) den definierten Pegel des Ausgangssignals (u_{A}) der Anordnung. Die Anordnung gestattet, möglichst alle Bauteile innerhalb der Anordnung mit Signalen, insbesondere mit Steuersignalen, gleichen Pegels zu betreiben, obwohl die von aussen der Anordnung zugeführten Signale, insbesonders Wechsel-Speisespannungen, innerhalb eines sehr grossen Pegelbereichs liegen können. Die Anordnung hat den Vorteil, dass die Bauteile im Innern der Anordnung nicht je nach Einsatzort mit unterschiedlichen Pegel betrieben werden und dementsprechend nicht für einen sehr grossen Pegelbereich ausgelegt sein müssen. Je nach weltweitem Einsatzort besitzt die Wechsel-Speisespannung der Anordnung einen Pegel, der z. B. zwischen 27 Volt und 276 Volt liegen kann. Die Anordnung hat den Vorteil, dass Sonderausführungen der Anordnung, eine entsprechend komplizierte Logistik und Lagerhaltung und sowie teure Lösungen vermieden werden.

## Beschreibung

Die Erfindung bezieht sich gemäss dem Oberbegriff des Anspruchs 1 auf eine Anordnung zur Erzeugung eines Ausgangssignals aus einem Eingangssignal in einem Elektrizitätszähler, einem Rundsteuerempfänger, einer Kombination derselben und/oder einem zugehörigen Zusatzgerät, wobei das Ausgangssignal unabhängig vom Pegel des Eingangssignals einen definierten Pegel besitzt.

Die Anordnung wird also in Elektrizitätszählern, Rundsteuerempfängern, kombinierten Elektrizitätszähler-Rundsteuerempfängern und/oder zugehörigen Zusatzgeräten, wie z. B. Tarifgeräten, Modeme, usw., verwendet. Diese aufgelisteten Geräten werden in der Regel weltweit vertrieben und können daher mit Eingangssignalen, insbesondere mit Wechsel-Speisespannungen gespeist werden, deren Pegel in einem sehr grossen Bereich, z. B. zwischen 27 Volt und 276 Volt liegen kann, was in der Regel zu Sonderausführungen der Geräte, einer entsprechend komplizierten Logistik und Lagerhaltung sowie zu teuren Lösungen führen kann.

Aus der US 5,457,621 und US 5,621,629 sind Speisegeräte für Elektrizitätszähler bekannt, die von Eingangsspannungen gespeist sind, die in einem sehr breiten Spannungsbereich liegen können.

Der Erfindung liegt die Aufgabe zugrunde, eine einfache und preisgünstige Anordnung der eingangs genannten Art zu verwirklichen, die es gestattet, möglichst alle Bauteile innerhalb der Anordnung mit Signalen, insbesondere mit Steuersignalen, gleichen Pegels zu betreiben, obwohl die von aussen der Anordnung zugeführten Signale, insbesonders Wechsel-Speisespannungen, innerhalb eines sehr grossen Pegelbereichs liegen können. Die erfindungsgemässe Anordnung hat den Vorteil, dass die Bauteile im Innern der Anordnung nicht je nach Einsatzort mit unterschiedlichen Pegel betrieben werden und dementsprechend nicht für einen sehr grossen Pegelbereich ausgelegt sein müssen, in dem sie korrekt funktionieren. Je nach weitweitem Einsatzort besitzt die Wechsel-Speisespannung der Anordnung, wie bereits erwähnt, einen Pegel, der z. B. zwischen 27 Volt und 276 Volt liegen kann, was ohne Gegenmassnahmen zu entsprechend unterschiedlichen Signalpegeln innerhalb der Anordnung führen kann, da diese in der Regel von den Pegeln der Wechsel-Speisespannung abgeleitet sind. Die erfindungsgemässe Anordnung hat somit den grossen Vorteil, dass Sonderausführungen der Anordnung, eine entsprechend komplizierte Logistik und Lagerhaltung und sowie teure Lösungen vermieden werden.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

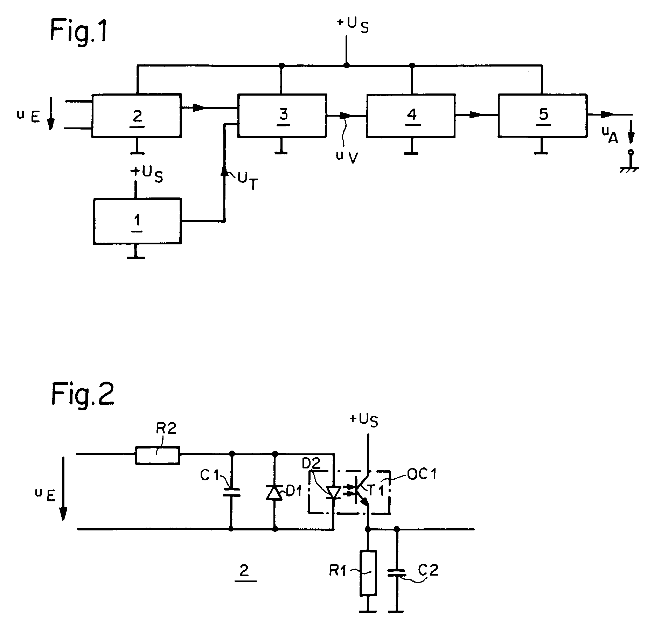

Ein Ausführungsbeispiel der Erfindung ist in der Zeichnung dargestellt und wird im folgenden näher beschrieben.
- Es zeigen: Fig. 1: ein Blockschaltbild einer erfindungsgemässen Anordnung und
- Fig. 2: ein Schaltbild einer galvanischen Trennungsschaltung.

Wie bereits erwähnt, wird die erfindungsgemässe Anordnung in einem Elektrizitätszähler und/oder einem Rundsteuerempfänger und/oder einem Zusatzgerät derselben verwendet, wobei das Zusatzgerät z. B. ein Tarifgerät ist. Die Anordnung und das Verfahren dienen zur Erzeugung eines Ausgangssignals u_{A} aus einem Eingangssignal u_{E}. Das letztere weist einen grossen Pegelbereich auf, der mindestens gleich dem zehnfachen Betrag seines minimalen Pegels ist. Das Ausgangssignal u_{A} besitzt unabhängig vom Pegel des Eingangssignals u_{E} einen definierten Pegel. Das Eingangs- und Ausgangssignal u_{E} und u_{A} der Anordnung sind vorzugsweise Steuersignale. Das Ausgangssignal u_{A} besitzt einen Logikwert "1" oder einen Logikwert "0". Der definierte Pegel ist dann vorzugsweise der Logikwert "1" der Steuersignale und maximal gleich einer Speise-Gleichspannung U_{S} der Anordnung und eines Mikroprozessors 1, wenn ein solcher in der Anordnung enthalten ist. Die Speise-Gleichspannung U_{S} beträgt z. B. 5 Volt und ist z. B. auf Masse bezogen. Im letzteren Fall stellt das Massepotential den Logikwert "0" der Steuersignal dar.

Das Eingangssignal u_{E} ist - vorzugsweise über eine galvanische Trennungsschaltung 2 - auf eine Vergleichsanordnung 3 geführt zum dortigem Vergleich mit einem Schwellwert U_{T} (siehe Fig. 1). Das Eingangssignal u_{E} der Anordnung ist bevorzugt ein Wechselsignal und dann über einen Gleichrichter D1 (siehe Fig.2) der galvanischen Trennungsschaltung 2 der Vergleichsanordnung 3 zugeführt. Das Wechselsignal ist vorzugsweise eine Wechselspannung, deren Effektivwert zwischen 27 Volt und 276 Volt liegt. In der Darstellung der Fig. 1 speist das Eingangssignal u_{E} zweipolig die galvanische Trennungsschaltung 2, deren Ausgang mit einem ersten Eingang der Vergleichsanordnung 3 verbunden ist, während an einem zweiten Eingang der letzteren der Schwellwert U_{T} ansteht. Der letztere ist eine der Vergleichsanordnung 3 zugeführte Referenzspannung, z. B. eine Gleichspannung, bei deren Überschreitung ein Ausgangssignal u_{V} der Vergleichsanordnung 3 - unabhängig vom Pegel des Eingangssignals u_{E} - den definierten Pegel des Ausgangssignals u_{A} der Anordnung besitzt. Der Wert des Schwellwertes U_{T} ist einstellbar, vorzugsweise mittels des Mikroprozessors 1, falls ein solcher vorhanden ist, was in der Fig. 1 angenommen wurde. Die Vergleichsanordnung 3 ist z. B. ein Komparator. Ihr ist bevorzugt ein Verzögerungsglied 4 und/oder eine Entprellschaltung 5 nachgeschaltet. In der Fig. 1 gilt die Annahme, dass der Ausgang der Vergleichsanordnung 3 in der angegebenen Reihenfolge über das Verzögerungsglied 4 und die Entprellschaltung 5 mit dem Ausgang der Anordnung verbunden ist, an dem die Ausgangsspannung u_{A} ansteht. Die auf Masse bezogene Speise-Gleichspannung U_{S} speist den Mikroprozessor 1, die galvanische Trennungsschaltung 2, die Vergleichsanordnung 3, das Verzögerungsglied 4 und die Entprellschaltung 5. Das Verzögerungsglied 4 ist z. B. ein RC-Glied und verhindert, dass ein Ausfall des Eingangssignals u_{E} kleiner als z. B. 200 ms nicht detektiert wird. Nach der Verzögerung ist noch eine Entprellung angebracht, die mittels der Entprellschaltung 5 realisiert wird, die z. B. aus einer Reihenschaltung zweier Schmitt-Trigger-Inverter besteht.

Die galvanische Trennungsschaltung 2 enthält (siehe Fig. 2) vorzugsweise einen Gleichrichter D1 in Einwegschaltung und einen Optokoppler OC1, der aus einer Leuchtdiode D2 und einen Phototransistor T1 besteht. Der Gleichrichter D1 und die Leuchtdiode D2 sind in Gegenrichtung parallel geschaltet und ihnen ist zusätzlich ein Kondensator C1 parallel geschaltet. Ein Emitter des Phototransistors T1, der gleichzeitig der Ausgang der Trennungsschaltung 2 ist, ist über eine Parallelschaltung eines Widerstandes R1 und eines Kondensators C2 mit Masse verbunden, während ein Kollektor des Phototransistors T1 am positiven Pol +U_{S} der Speise-Gleichspannung U_{S} angeschlossen ist. Ein erster der beiden Pole des Eingangssignals u_{E} ist über einen Widerstand R2 mit einem ersten Pol der Parallelschaltung D1;D2;C1 des Gleichrichters D1, der Leuchtdiode D2 und des Kondensators C1 verbunden, während ein zweiter der beiden Pole des Eingangssignals u_{E} unmittelbar auf einen zweiten Pol der Parallelschaltung D1;D2;C1 geführt ist.

## Patentansprüche

1. Anordnung zur Erzeugung eines Ausgangssignals (u_{A}) aus einem Eingangssignal (u_{E}) in einem Elektrizitätszähler, einem Rundsteuerempfänger, einer Kombination derselben und/oder einem zugehörigen Zusatzgerät, wobei das Ausgangssignal (u_{A}) unabhängig vom Pegel des Eingangssignals (u_{E}) einen definierten Pegel besitzt, dadurch gekennzeichnet, dass das Eingangssignal (u_{E}) einen grossen Pegelbereich aufweist und auf eine Vergleichsanordnung (3) geführt ist zum dortigem Vergleich mit einem Schwellwert (U_{T}) und dass ein Ausgangssignal (u_{V}) der Vergleichsanordnung (3) unabhängig vom Pegel des Eingangssignals (u_{E}) den definierten Pegel des Ausgangssignals (u_{A}) der Anordnung besitzt.

2. Anordnung nach Anspruch 1, dadurch gekennzeichnet, dass der Pegelbereich des Eingangssignals (u_{E}) mindestens gleich dem zehnfachen Betrag seines minimalen Pegels ist.

3. Anordnung nach Anspruch 1 oder 2, dadurch gekennzeichnet, dass das Eingangs- und Ausgangssignal (u_{E}, u_{A}), der Anordnung Steuersignale sind.

4. Anordnung nach einem der Ansprüche 1 bis 3, dadurch gekennzeichnet, dass das Eingangssignal (u_{E}) der Anordnung ein Wechselsignal ist und über einen Gleichrichter (D1) der Vergleichsanordnung (3) zugeführt ist.

5. Anordnung nach Anspruch 4, dadurch gekennzeichnet, dass das Wechselsignal eine Wechselspannung ist, deren Effektivwert zwischen 27 Volt und 276 Volt liegt.

6. Anordnung nach einem der Ansprüche 1 bis 5, dadurch gekennzeichnet, dass das Eingangssignal (u_{E}) der Anordnung über eine galvanische Trennungsschaltung (2) auf die Vergleichsanordnung (3) geführt ist.

7. Anordnung nach Anspruch 6, dadurch gekennzeichnet, dass die galvanische Trennungsschaltung (2) einen Optokoppler (OC1) enthält.

8. Anordnung nach einem der Ansprüche 1 bis 7, dadurch gekennzeichnet, dass der Schwellwert (U_{T}) eine der Vergleichsanordnung (3) zugeführte Referenzspannung ist, bei deren Überschreitung ein Ausgangssignal (u_{V}) der Vergleichsanordnung (3) den definierten Pegel des Ausgangssignals (u_{A}) der Anordnung besitzt.

9. Anordnung nach einem der Ansprüche 1 bis 8, dadurch gekennzeichnet, dass der Wert des Schwellwertes (U_{T}) einstellbar ist.

10. Anordnung nach einem der Ansprüche 1 bis 9, dadurch gekennzeichnet, dass der Wert des Schwellwertes (U_{T}) mittels eines Mikroprozessors (1) einstellbar ist.

11. Anordnung nach einem der Ansprüche 1 bis 10, dadurch gekennzeichnet, dass der Vergleichsanordnung (3) ein Verzögerungsglied (4) nachgeschaltet ist.

12. Anordnung nach einem der Ansprüche 1 bis 11, dadurch gekennzeichnet, dass der Vergleichsanordnung (3) eine Entprellschaltung (5) nachgeschaltet ist.
